# EUROPEAN PATENT APPLICATION

(11) **EP 4 687 387 A1**
(43) Date of publication of application: **04.02.2026**
(21) Application number: 25174499.1
(22) Date of filing: 06.05.2025
(51) Int. Cl.: H05K 7/20

(54) **IMMERSION COOLING SYSTEM AND BUBBLING-ASSISTED IMMERSION TANK**

(30) Priority: 02.08.2024 TW 113129035
(71) Applicant: Wistron NeWeb Corporation, Hsinchu 308 (TW)
(72) Inventor: JIN, Yi Chun, Hsinchu (TW); PAN, Han-Chang, Hsinchu (TW); FAN, Jui Ting, Hsinchu (TW); WANG, Ming-Tsung, Hsinchu (TW); WANG, Xiao Zhe, Hsinchu (TW); KUO, Ming Ying, Hsinchu (TW)
(74) Representative: Vossius & Partner Patentanwälte Rechtsanwälte mbB

(57) **Abstract**

The immersion cooling system includes a bubbling-assisted immersion tank and a coolant distribution device. The bubbling-assisted immersion tank includes a tank body and a bubbling assisted-module. The tank body includes an accommodation space provided with a cooling liquid. The bubbling-assisted module is disposed at a bottom of the accommodating space and is configured to transport a plurality of auxiliary bubbles into the cooling liquid so that the auxiliary bubbles are discharged from a top of the accommodating space through an object to be cooled. The coolant distribution device is connected to the tank body and is configured to introduce and discharge the cooling liquid from the accommodation space. Thus, the cooling efficiency of the immersion cooling system can be improved.

## Description

### BACKGROUND

### Technical Field

The present disclosure relates to a cooling system, and more particularly to an immersion cooling system and a bubbling-assisted immersion tank.

### Description of Related Art

With the development of Artificial Intelligence (AI) and Machine Learning (ML) technologies, the demand for cooling systems applied to high-performance servers has been increasing. Existing servers are cooled by using immersion cooling systems. Immersion cooling systems work by directly submerging servers in insulating liquids, allowing heat from the components to be directly transferred to the liquid. The heated insulating liquid is then circulated back to the tank through natural convection with the aid of a motor and a heat exchanger, ensuring continuous cooling for the servers.

However, during the cooling circulation process, the high-density server installations and the high viscosity of the insulating liquid significantly increase the fluid resistance. To ensure that the servers operate continuously at safe temperatures, high-lift motors are required to maintain the circulation of large amounts of insulating liquid. This greatly increases the motor's workload and the power consumption, which is detrimental to achieving an optimal Power Usage Effectiveness (PUE).

In view of this, there is currently a lack of immersion cooling systems and bubbling-assisted immersion tank in the market that can reduce the motor workload and the power consumption while providing high-performance cooling. As a result, industry stakeholders are actively seeking solutions to address this issue.

### SUMMARY

One aspect of the present disclosure provides an immersion cooling system, including a bubbling-assisted immersion tank and a coolant distribution device. The bubbling-assisted immersion tank includes a tank body and a bubbling-assisted module. The tank body includes an accommodation space provided with a cooling liquid. The bubbling-assisted module is disposed at the bottom of the accommodation space and is configured to transport a plurality of auxiliary bubbles into the cooling liquid so that the auxiliary bubbles are discharged from a top of the accommodation space through an object to be cooled. The coolant distribution device is connected to the tank body and is configured to introduce and discharge the cooling liquid from the accommodation space.

According to the immersion cooling system of the aforementioned aspect, wherein the bubbling-assisted module includes at least one gas manifold and a gas pipeline. The at least one gas manifold includes a plurality of openings for generating the auxiliary bubbles. The gas pipeline is connected to the at least one gas manifold and is configured to guide a gas into the at least one gas manifold.

According to the immersion cooling system of the aforementioned aspect, wherein the bubbling-assisted immersion tank further includes at least one heat-conducting carrier. The at least one heat-conducting carrier is disposed on the object to be cooled. The at least one gas manifold is fixed along a direction to the at least one heat-conducting carrier.

According to the immersion cooling system of the aforementioned aspect, wherein the at least one heat-conducting carrier includes a plurality of fins, which are spaced apart along the direction, and the openings of the at least one gas manifold are positioned between the fins, respectively.

According to the immersion cooling system of the aforementioned aspect, wherein a fin spacing exists between each adjacent two of the fins, and each of the auxiliary bubbles has a bubble size. A ratio of the bubble size to the fin spacing is between 0.2 and 0.3.

According to the immersion cooling system of the aforementioned aspect, wherein the auxiliary bubbles are nitrogen or carbon dioxide.

According to the immersion cooling system of the aforementioned aspect, wherein the tank body further includes an outlet and an inlet. The outlet is communicating with the accommodation space and is configured to discharge the cooling liquid from the accommodation space to the coolant distribution device through an outlet pipe. The inlet is communicating with the accommodation space and is configured to introduce the cooling liquid from the coolant distribution device to the accommodation space through an inlet pipe.

According to the immersion cooling system of the aforementioned aspect, wherein the outlet is located near the top of the accommodation space and below a liquid surface of the cooling liquid in the accommodation space, and the inlet is located near the bottom of the accommodation space.

According to the immersion cooling system of the aforementioned aspect, the immersion cooling system further includes a pump connected between the coolant distribution device and the outlet pipe and is configured to discharge the cooling liquid from the accommodation space through the outlet.

According to the immersion cooling system of the aforementioned aspect, wherein the bubbling-assisted immersion tank further includes at least one guiding plate component. The at least one guiding plate component is disposed on at least one heat source of the object to be cooled, tapering from the bottom to the top of the accommodation space to guide the auxiliary bubbles and concentrate the auxiliary bubbles on the at least one heat source.

Another aspect of the present disclosure provides a bubbling-assisted immersion tank, including a tank body and a bubbling-assisted module. The tank body includes an accommodation space provided with a cooling liquid. The bubbling-assisted module is disposed at the bottom of the accommodation space and is configured to transport a plurality of auxiliary bubbles into the cooling liquid so that the auxiliary bubbles are discharged from a top of the accommodation space through an object to be cooled.

According to the bubbling-assisted immersion tank of the aforementioned aspect, wherein the bubbling-assisted module includes at least one gas manifold and a gas pipeline. The at least one gas manifold includes a plurality of openings for generating the auxiliary bubbles. The gas pipeline is connected to the at least one gas manifold and is configured to guide a gas into the at least one gas manifold.

According to the bubbling-assisted immersion tank of the aforementioned aspect, the bubbling-assisted immersion tank further includes at least one heat-conducting carrier. The at least one heat-conducting carrier is disposed on the object to be cooled. The at least one gas manifold is fixed along a direction to the at least one heat-conducting carrier.

According to the bubbling-assisted immersion tank of the aforementioned aspect, wherein the at least one heat-conducting carrier includes a plurality of fins, which are spaced apart along the direction, and the openings of the at least one gas manifold are positioned between the fins, respectively.

According to the bubbling-assisted immersion tank of the aforementioned aspect, wherein a fin spacing exists between each adjacent two of the fins, and each of the auxiliary bubbles has a bubble size. A ratio of the bubble size to the fin spacing is between 0.2 and 0.3.

According to the bubbling-assisted immersion tank of the aforementioned aspect, wherein the bubbling-assisted module further includes a gas pump. The gas pump is connected to the gas pipeline and configured to transport the gas to the at least one gas manifold.

According to the bubbling-assisted immersion tank of the aforementioned aspect, wherein the auxiliary bubbles are nitrogen or carbon dioxide.

According to the bubbling-assisted immersion tank of the aforementioned aspect, wherein the tank body further includes an outlet and an inlet. The outlet is communicating with the accommodation space and is configured for discharging the cooling liquid. The inlet is communicating with the accommodation space and configured for introducing the cooling liquid.

According to the bubbling-assisted immersion tank of the aforementioned aspect, wherein the outlet is located near the top of the accommodation space and below a liquid surface of the cooling liquid in the accommodation space, and the inlet is located near the bottom of the accommodation space.

According to the bubbling-assisted immersion tank of the aforementioned aspect, the bubbling-assisted immersion tank further includes at least one guiding plate component. The at least one guiding plate component is disposed on at least one heat source of the object to be cooled, tapering from the bottom to the top of the accommodation space to guide the auxiliary bubbles and concentrate the auxiliary bubbles on the at least one heat source.

### BRIEF DESCRIPTION OF THE DRAWINGS

The present disclosure can be more fully understood by reading the following detailed description of the embodiment, with reference made to the accompanying drawings as follows:
FIG. 1 is a schematic diagram of an immersion cooling system according to a first embodiment of the present disclosure.
FIG. 2 is a schematic diagram of a bubbling-assisted immersion tank shown in FIG. 1.
FIG. 3A is a schematic diagram of a heat-conducting carrier of the bubbling-assisted immersion tank in a second embodiment of the present disclosure.
FIG. 3B is a top view of the heat-conducting carrier shown in FIG. 3A.
FIG. 4A is a schematic diagram of the heat-conducting carrier of the bubbling-assisted immersion tank in a third embodiment of the present disclosure.
FIG. 4B is a top view of the heat-conducting carrier shown in FIG. 4A.
FIG. 5 is a schematic diagram of the heat-conducting carrier of the bubbling-assisted immersion tank in a fourth embodiment of the present disclosure.
FIG. 6 is a schematic diagram of a guiding plate component of the present disclosure.

### DETAILED DESCRIPTION

The present disclosure is more particularly described in the following embodiments that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a", "an" and "the" includes plural reference, and the meaning of "in" includes "in" and "on". Titles or subtitles can be used herein for the convenience of a reader, which shall have no influence on the scope of the present disclosure.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first", "second" or "third" can be used to describe various components, signals or the like, which are for distinguishing one component/signal from another one only, and are not intended to, nor should be construed to impose any substantive limitations on the components, signals or the like.

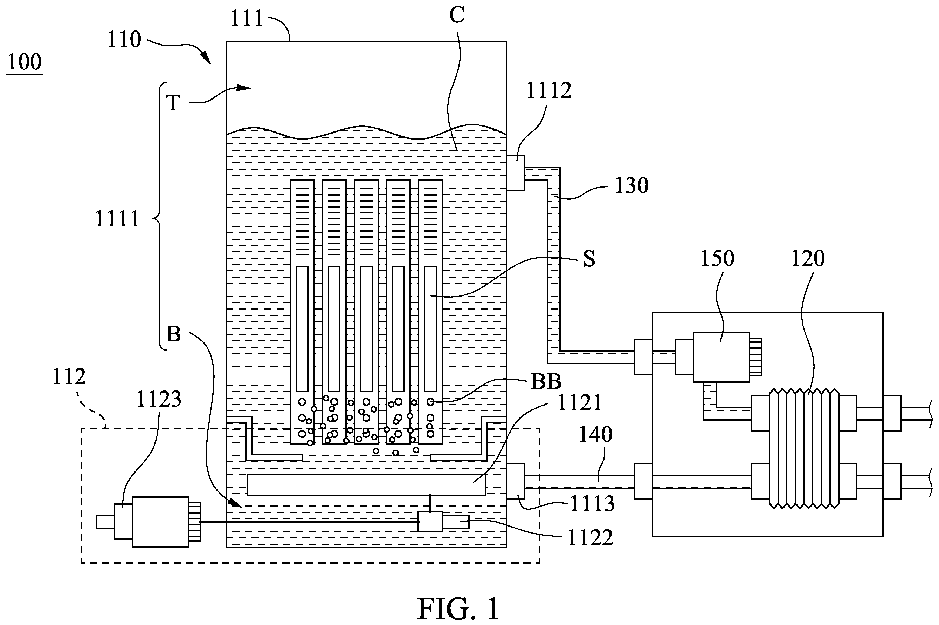

Please refer to FIG. 1. FIG. 1 is a schematic diagram of an immersion cooling system 100 according to a first embodiment of the present disclosure. The immersion cooling system 100 includes a bubbling-assisted immersion tank 110, a coolant distribution device 120, an outlet pipe 130, an inlet pipe 140, and a pump 150. The outlet pipe 130 connects to the bubbling-assisted immersion tank 110, the inlet pipe 140 connects between the bubbling-assisted immersion tank 110 and the coolant distribution device 120, and the pump 150 connects between the coolant distribution device 120 and the outlet pipe 130.

The bubbling-assisted immersion tank 110 and the coolant distribution device 120 form a cooling circuit through the outlet pipe 130 and the inlet pipe 140. The bubbling-assisted immersion tank 110 is configured to immerse an object to be cooled S in a cooling liquid C. The coolant distribution device 120 is configured to introduce and discharge the cooling liquid C from the bubbling-assisted immersion tank 110. The pump 150 drives the cooling liquid C to discharge from the bubbling-assisted immersion tank 110 through the outlet pipe 130 and to introduce into the bubbling-assisted immersion tank 110 through the inlet pipe 140. In the first embodiment, the object to be cooled S can be a server, but the present disclosure is not limited thereto.

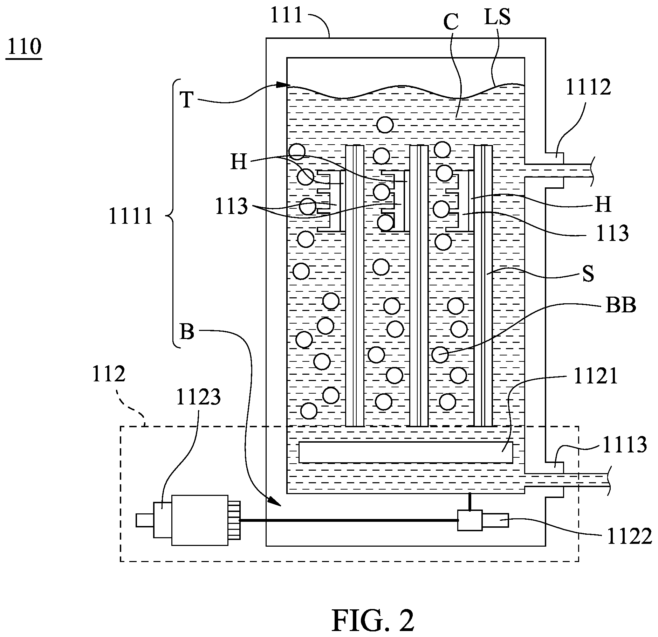

Please refer to FIG. 1 and FIG. 2. FIG. 2 is a schematic diagram of the bubbling-assisted immersion tank 110 shown in FIG. 1. The bubbling-assisted immersion tank 110 includes a tank body 111 and a bubbling-assisted module 112. The tank body 111 includes an accommodation space 1111, an outlet 1112, and an inlet 1113. The outlet 1112 and the inlet 1113 communicate with the accommodation space 1111. The outlet 1112 is located near a top T of the accommodation space 1111, and the inlet 1113 is located near a bottom B of the accommodation space 1111.

The accommodation space 1111 is provided with a cooling liquid C, and the coolant distribution device 120 is connected to the tank body 111 to introduce and discharge the cooling liquid C from the accommodation space 1111. The outlet 1112 allows the pump 150 to discharge the cooling liquid C from the accommodation space 1111 to the coolant distribution device 120 through the outlet pipe 130. The inlet 1113 allows the pump 150 to introduce the cooling liquid C from the coolant distribution device 120 to the accommodation space 1111 through the inlet pipe 140.

The bubbling-assisted module 112 is installed at the bottom B of the accommodation space 1111 and is configured to transport a plurality of auxiliary bubbles BB into the cooling liquid C, allowing the auxiliary bubbles BB to discharge toward the top T of the accommodation space 1111 through the object to be cooled S. In the first embodiment, the auxiliary bubbles BB can be nitrogen or carbon dioxide, but the present disclosure is not limited thereto.

The bubbling-assisted module 112 includes at least one gas manifold 1121, a gas pipeline 1122, and a gas pump 1123. The gas pipeline 1122 is connected to at least one gas manifold 1121, and the gas pump 1123 is connected to the gas pipeline 1122. The gas manifold 1121 includes a plurality of openings for generating the auxiliary bubbles BB. The gas pipeline 1122 is configured to guide a gas into at least one gas manifold 1121. The gas pump 1123 is configured to transport the gas to the at least one gas manifold 1121. The gas can be compressed air (Clean Dry Air, CDA) with a relative humidity (moisture content) of less than or equal to 12.82% under standard atmospheric pressure. Additionally, the temperature of the auxiliary bubbles BB can be controlled to be lower than the operating (ambient) temperature of the tank body 111. Generally, the operating temperature of the tank body 111 is controlled to be below 40 degrees Celsius. The aforementioned control of gas humidity and the temperature of the auxiliary bubbles BB, whether implemented individually or in combination, can prevent condensation of the introduced gas and enhance the heat dissipation efficiency. In the first embodiment, at least one gas manifold 1121 is installed at the bottom B of the accommodation space 1111; however, the present disclosure is not limited thereto.

Specifically, the auxiliary bubbles BB flow from the bottom B to the top T, due to the buoyancy resulting from their density difference compared to the cooling liquid C. This enhances the flow speed and circulation rate of the cooling liquid C while disrupting the thermal boundary layer. Consequently, the flow field circulation of the cooling liquid C is improved, further enhancing the cooling efficiency of the bubbling-assisted immersion tank 110.

It should be noted that the bubbling-assisted module 112 can regulate the injection rate, size, density, distribution, and even temperature of the auxiliary bubbles BB by adjusting the gas flow rate through the gas pump 1123, the size of the openings in the gas manifold 1121, and the density of the openings in the gas manifold 1121. This allows the bubbling-assisted immersion tank 110 to tailor its heat dissipation performance to the cooling requirements of the object to be cooled S.

Additionally, as shown in FIG. 2, the outlet 1112 of the tank body 111 is positioned below the liquid surface LS of the cooling liquid C. This allows the auxiliary bubbles BB to naturally dissipate upon reaching the liquid surface LS, thereby preventing the auxiliary bubbles BB from being drawn into the pump 150, which could cause cavitation damage to the equipment.

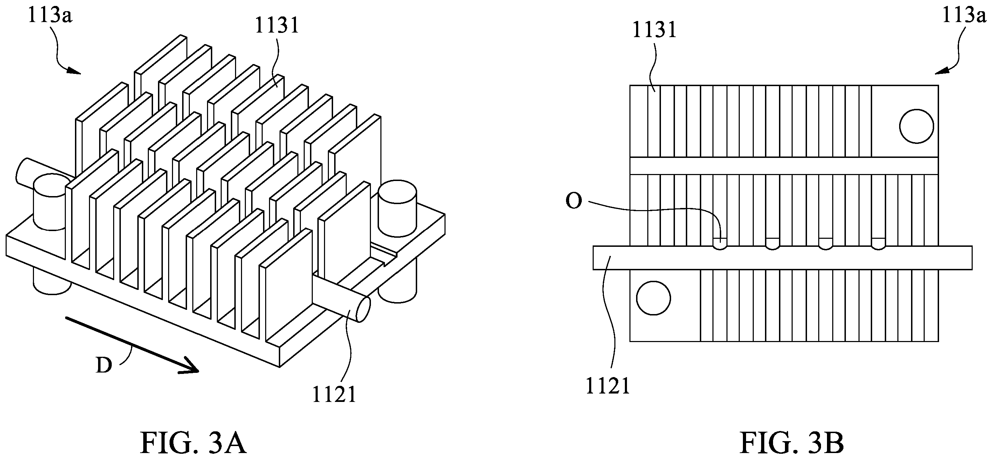

Furthermore, the bubbling-assisted immersion tank 110 can further include at least one heat-conducting carrier 113. The object to be cooled S includes at least one heat source H, and the at least one heat-conducting carrier 113 is respectively installed on the at least one heat source H (as shown in FIG. 2). The heat-conducting carrier 113 is configured to secure one or more gas manifolds 1121 (illustrated in FIG. 3A to FIG. 5) to provide the required airflow at the position of the heat source H. In the first embodiment, the heat-conducting carrier 113 can be a heat-dissipating fin or a metal block, and the heat source H can be located at the CPU or MAC components of the server. However, the present disclosure is not limited thereto.

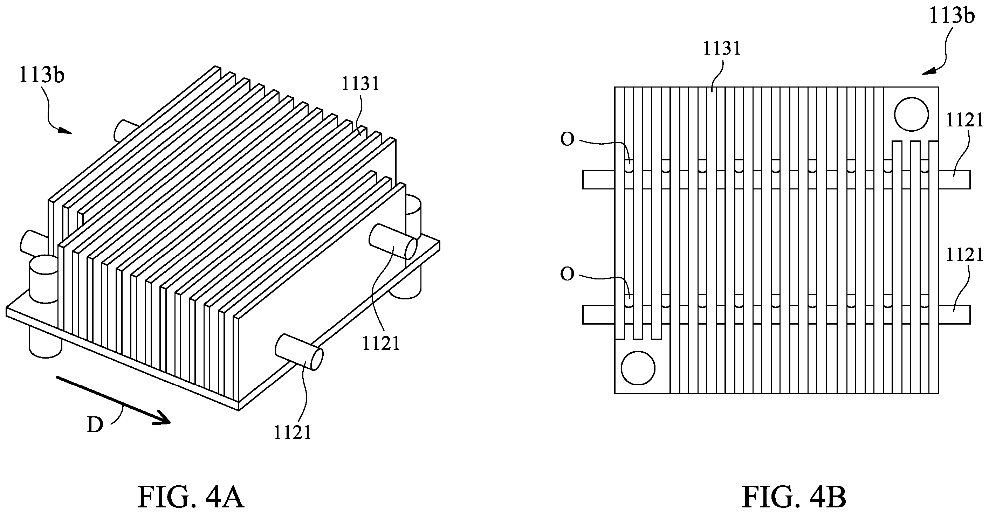

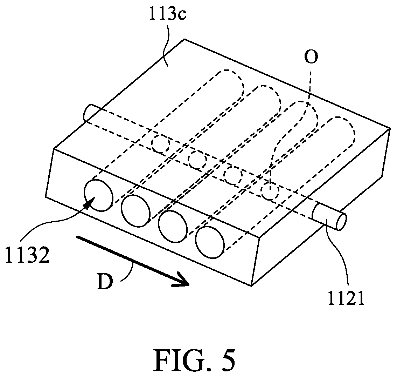

Please refer to FIG. 1 to FIG. 5. FIG. 3A is a schematic diagram of the heat-conducting carrier 113a of the bubbling-assisted immersion tank in the second embodiment of the present disclosure. FIG. 3B is a top view of the heat-conducting carrier 113a shown in FIG. 3A. FIG. 4A is a schematic diagram of the heat-conducting carrier 113b of the bubbling-assisted immersion tank in the third embodiment of the present disclosure. FIG. 4B is a top view of the heat-conducting carrier 113b shown in FIG. 4A. FIG. 5 is a schematic diagram of the heat-conducting carrier 113c of the bubbling-assisted immersion tank in the fourth embodiment of the present disclosure. It should be noted that the bubbling-assisted immersion tanks in the second, third, and fourth embodiments shown in FIG. 3A to FIG. 5 may be the same as or similar to the first embodiment. Subsequent descriptions will correspond to the disclosures in FIG. 1 and FIG. 2, but the present disclosure is not limited thereto.

As shown in FIG. 3A to FIG. 5, the heat-conducting carriers 113a, 113b, and 113c enable the at least one gas manifold 1121 to be fixed along a direction D to the at least one of the heat-conducting carriers 113a, 113b, or 113c.

As shown in FIG. 3A and FIG. 3B, the heat-conducting carrier 113a in the second embodiment includes multiple fins 1131, which are spaced apart along the direction D. The fins 1131 are divided into three blocks, with grooves (not labeled) between the blocks. The gas manifold 1121 is positioned in the grooves along the direction D, and the openings O of the gas manifold 1121 are located between the fins 1131, respectively. A fin spacing exists between each adjacent two of the fins 1131, and each of the auxiliary bubbles (not shown) has a bubble size determined by the size of the openings O. In the second embodiment, the ratio of the bubble size to the fin spacing is between 0.2 and 0.3, with an optimal ratio of 0.25, but the present disclosure is not limited thereto.

As shown in FIG. 4A and FIG. 4B, the heat-conducting carrier 113b in the third embodiment includes a plurality of fins 1131, which are spaced apart along the direction D. The gas manifold 1121 is positioned in the perforations created along the direction D on the fins 1131. In the third embodiment, the placement of the openings O on the gas manifold 1121, as well as the ratio of bubble size to fin spacing, are the same as in the second embodiment and will not be redundantly described here.

As shown in FIG. 5, the heat-conducting carrier 113c in the fourth embodiment is a heat-conducting metal block that includes multiple perforations 1132, which are spaced apart along the direction D. The gas manifold 1121 is positioned in the perforations created along the direction D on the heat-conducting metal block. The openings O on the gas manifold 1121 correspond to the perforations 1132 on the heat-conducting carrier 113c, respectively. This arrangement not only avoids disturbances in the cooling liquid flow (not shown) but also accelerates the flow of cooling liquid through the heat-conducting carrier 113c, thereby enhancing the heat dissipation performance.

Thus, by simply machining the heat-conducting carrier 113 to secure the gas manifold 1121, the required airflow can be directed to the position of the heat source H. Furthermore, this ensures that the auxiliary bubbles BB accurately flow through the heat source H, thereby improving the cooling effect on the heat source H.

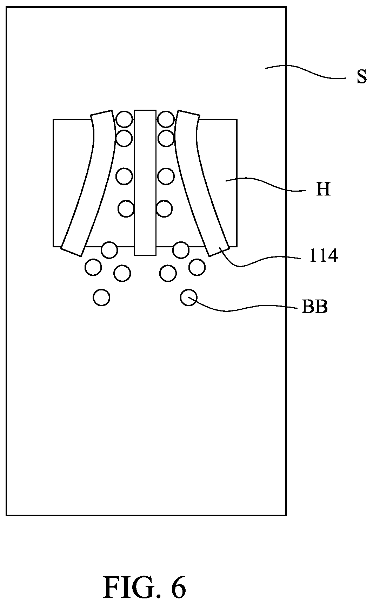

Please refer to FIG. 1, FIG. 2, and FIG. 6. FIG. 6 is a schematic diagram of a guiding plate component 114 of the present disclosure. The bubbling-assisted immersion tank 110 can further include at least one guiding plate component 114, which is installed on the at least one heat source H of the object to be cooled S. The guiding plate component 114 tapers from the bottom B to the top T of the accommodation space 1111 to guide the auxiliary bubbles BB, thereby concentrating the auxiliary bubbles BB on the heat source H and enhancing the local cooling effect on the object to be cooled S.

From the above embodiments, the present disclosure offers the following advantages: (1) The flow of auxiliary bubbles promotes the circulation of the cooling liquid, further enhancing the cooling effect. (2) By securing the gas manifold with the heat-conducting carrier, the required airflow can be provided to the position of the heat source, ensuring the auxiliary bubbles accurately flow through the heat source, thereby improving the cooling effect on the heat source. (3) The auxiliary bubbles accelerate the flow of the cooling liquid, helping to maintain the operation of the object to be cooled and reducing the power consumption of the pump, thereby improving power usage effectiveness and aligning with energy-saving and environmental protection trends. (4) By adjusting the injection rate, size, density, distribution, and even temperature of the auxiliary bubbles, the system can be adapted to cool various high-performance electronic components. (5) The stable cooling performance provided by the bubbling-assisted immersion tank reduces the maintenance requirements for the object to be cooled, thereby extending its service life.

## Claims

1. An immersion cooling system (100), **characterized in** comprising:
a bubbling-assisted immersion tank (110), comprising:
a tank body (111) comprising an accommodation space (1111) provided with a cooling liquid (C); and
a bubbling-assisted module (112) disposed at a bottom (B) of the accommodation space (1111) and configured to transport a plurality of auxiliary bubbles (BB) into the cooling liquid (C) so that the auxiliary bubbles (BB) are discharged from a top (T) of the accommodation space (1111) through an object to be cooled; and
a coolant distribution device (120) connected to the tank body (111) and configured to introduce and discharge the cooling liquid (C) from the accommodation space (1111).

2. The immersion cooling system (100) of claim 1, wherein the bubbling-assisted module (112) comprises:
at least one gas manifold (1121) comprising a plurality of openings (O) for generating the auxiliary bubbles (BB); and
a gas pipeline (1122) connected to the at least one gas manifold (1121) and configured to guide a gas into the at least one gas manifold (1121).

3. The immersion cooling system (100) of any of claims 1-2, wherein the bubbling-assisted immersion tank (110) further comprises:
at least one heat-conducting carrier (113) disposed on the object to be cooled;
wherein the at least one gas manifold (1121) is fixed along a direction (D) to the at least one heat-conducting carrier (113).

4. The immersion cooling system (100) of any of claims 1-3, wherein the at least one heat-conducting carrier (113) comprises a plurality of fins (1131), which are spaced apart along the direction (D), and the openings (O) of the at least one gas manifold (1121) are positioned between the fins (1131), respectively.

5. The immersion cooling system (100) of any of claims 1-4, wherein a fin spacing exists between each adjacent two of the fins (1131), and each of the auxiliary bubbles (BB) has a bubble size;
wherein a ratio of the bubble size to the fin spacing is between 0.2 and 0.3.

6. The immersion cooling system (100) of any of claims 1-5, wherein the auxiliary bubbles (BB) are nitrogen or carbon dioxide.

7. The immersion cooling system (100) of any of claims 1-6, wherein the tank body (111) further comprises:
an outlet (1112) communicating with the accommodation space (1111) and configured to discharge the cooling liquid (C) from the accommodation space (1111) to the coolant distribution device (120) through an outlet pipe (130); and
an inlet (1113) communicating with the accommodation space (1111) and configured to introduce the cooling liquid (C) from the coolant distribution device (120) to the accommodation space (1111) through an inlet pipe (140).

8. The immersion cooling system (100) of any of claims 1-7, wherein the outlet (1112) is located near the top (T) of the accommodation space (1111) and below a liquid surface of the cooling liquid (C) in the accommodation space (1111), and the inlet (1113) is located near the bottom (B) of the accommodation space (1111).

9. The immersion cooling system (100) of any of claims 1-8, further comprising a pump (150) connected between the coolant distribution device (120) and the outlet pipe (130) and configured to discharge the cooling liquid (C) from the accommodation space (1111) through the outlet (1112).

10. The immersion cooling system (100) any of claims 1-9, wherein the bubbling-assisted immersion tank (110) further comprises:
at least one guiding plate component (114) disposed on at least one heat source (H) of the object to be cooled, tapering from the bottom (B) to the top (T) of the accommodation space (1111) to guide the auxiliary bubbles (BB) and concentrate the auxiliary bubbles (BB) on the at least one heat source (H).

11. A bubbling-assisted immersion tank (110), **characterized in** comprising:
a tank body (111) comprising an accommodation space (1111) provided with a cooling liquid (C); and
a bubbling-assisted module (112) disposed at a bottom (B) of the accommodation space (1111) and configured to transport a plurality of auxiliary bubbles (BB) into the cooling liquid (C) so that the auxiliary bubbles (BB) are discharged from a top (T) of the accommodation space (1111) through an object to be cooled.

12. The bubbling-assisted immersion tank (110) of claim 11, wherein the bubbling-assisted module (112) comprises:
at least one gas manifold (1121) comprising a plurality of openings (O) for generating the auxiliary bubbles (BB); and
a gas pipeline (1122) connected to the at least one gas manifold (1121) and configured to guide a gas into the at least one gas manifold (1121).

13. The bubbling-assisted immersion tank (110) of any of claims 11-12, further comprising:
at least one heat-conducting carrier (113) disposed on the object to be cooled;
wherein the at least one gas manifold (1121) is fixed along a direction (D) to the at least one heat-conducting carrier (113).

14. The bubbling-assisted immersion tank (110) of any of claims 11-13, wherein the at least one heat-conducting carrier (113) comprises a plurality of fins, which are spaced apart along the direction (D), and the openings (O) of the at least one gas manifold (1121) are positioned between the fins (1131), respectively.

15. The bubbling-assisted immersion tank (110) of any of claims 11-14, wherein a fin spacing exists between each adjacent two of the fins (1131), and each of the auxiliary bubbles (BB) has a bubble size;
wherein a ratio of the bubble size to the fin spacing is between 0.2 and 0.3.

16. The bubbling-assisted immersion tank (110) of any of claims 11-15, wherein the bubbling-assisted module (112) further comprises:
a gas pump (1123) connected to the gas pipeline (1122) and configured to transport the gas to the at least one gas manifold (1121).

17. The bubbling-assisted immersion tank (110) of any of claims 11-16, wherein the auxiliary bubbles (BB) are nitrogen or carbon dioxide.

18. The bubbling-assisted immersion tank (110) of any of claims 11-17, wherein the tank body (111) further comprises:
an outlet (1112) communicating with the accommodation space (1111) and configured for discharging the cooling liquid (C); and
an inlet (1113) communicating with the accommodation space (1111) and configured for introducing the cooling liquid (C).

19. The bubbling-assisted immersion tank (110) of any of claims 11-18, wherein the outlet (1112) is located near the top (T) of the accommodation space (1111) and below a liquid surface of the cooling liquid (C) in the accommodation space (1111), and the inlet (1113) is located near the bottom (B) of the accommodation space (1111).

20. The bubbling-assisted immersion tank (110) of any of claims 11-19, further comprising:
at least one guiding plate component (114) disposed on at least one heat source (H) of the object to be cooled, tapering from the bottom (B) to the top (T) of the accommodation space (1111) to guide the auxiliary bubbles (BB) and concentrate the auxiliary bubbles (BB) on the at least one heat source (H).
